# EUROPEAN PATENT APPLICATION

(11) **EP 4 722 425 A1**
(43) Date of publication of application: **08.04.2026**
(21) Application number: 25207070.1
(22) Date of filing: 07.10.2025
(51) Int. Cl.: C30B 25/18, C30B 29/02, C30B 29/46, C30B 29/60, C30B 29/68

(54) **MOIRÉ MATERIAL BASED ON VAN DER WAALS STACKING STRUCTURE, METHOD OF PREPARING THE SAME THROUGH HYPOTAXIAL GROWTH, AND ELECTRONIC DEVICE INCLUDING THE MOIRÉ MATERIAL**

(30) Priority: 07.10.2024 KR 20240136012
(71) Applicant: Seoul National University R&DB Foundation, Seoul 08826 (KR)
(72) Inventor: LEE, Gwan Hyoung, SEOUL (KR); MOON, Dong Hoon, SEOUL (KR)
(74) Representative: Lavoix

(57) **Abstract**

Provided are a moiré material based on a van der Waals stacking structure, a method of preparing the moiré material through hypotaxial growth, and an electronic device including the moiré material. The moiré material based on a van der Waals stacking structure includes a multi-layered thin-film structure in which each layer has an independent crystal orientation and an independent crystal structure in a vertical direction, the multi-layered thin-film structure having interference fringes of the same or different periodic patterns in a horizontal direction of a single plane, depending on a superimposed angle among layers, or showing an atomic reconstruction phenomenon in a plane.

## Description

### CROSS-REFERENCE TO RELATED APPLICATION

This application is based on and claims priority under 35 U.S.C. §119 to Korean Patent Application No. 10-2024-0136012, filed on October 7, 2024, in the Korean Intellectual Property Office, the disclosure of which is incorporated by reference herein in its entirety.

### BACKGROUND

### 1. Field

The disclosure relates to a moiré material based on a van der Waals stacking structure, a method of preparing the moiré material through hypotaxial growth, and an electronic device including the moiré material.

This study was conducted with the support of the Samsung Science & Technology Foundation.

### 2. Description of the Related Art

As semiconductor technology advances and becomes more complex, the demand for high-quality two-dimensional semiconductor materials with excellent electrical, thermal, and mechanical properties is increasing. Chemical vapor deposition (CVD) growth methods have been widely used to manufacture such two-dimensional semiconductor materials. Researchers have made various attempts to manufacture two-dimensional semiconductor materials with controlled thickness, enhanced grain size, and reduced defects such as grain boundaries and vacancy, by using CVD growth methods.

Among these, epitaxial growth, which is a growth method for two-dimensional materials in an oriented manner on a high-crystalline substrate, has received much attention. Epitaxial growth is a technique in which single crystals are grown on a single-crystal substrate to preserve the crystal alignment with the underlying material and to induce the unidirectional growth of grains. However, such epitaxial growth is limited in the selection of substrates because a thin film to be grown and a substrate must have similar crystal structures and lattice constants, and a process of transferring the grown material to another substrate is required for application in a final device.

Meanwhile, moiré materials manufactured by stacking two-dimensional materials to have a stacking angle attract great interest because they have various quantum effects and can be applied to various quantum devices. However, the manufacturing of moiré materials is currently available only in exfoliated flake units, and physical stacking through a separate physical transfer process is required.

In addition, the fabrication of moiré patterns through physical stacking of exfoliated flakes has limitations in fabrication of super moiré patterns of three or more layers, stacking of heterogeneous materials, and fabrication of large-area moiré patterns. The preparation of moiré materials through some CVD methods have been reported, but the area of moiré materials is small, at tens of microns, and the moiré materials are formed arbitrarily, so that the stacking angle cannot be controlled.

Accordingly, there is still a need for a moiré material based on a van der Waals stacking structure that enables large-area growth with various combinations and stacking angles of high-quality two-dimensional materials, a method of preparing the moiré material through hypotaxial growth, and an electronic device including the moiré material.

### SUMMARY

An aspect is to provide a moiré material based on a van der Waals stacking structure, including a multi-layered thin-film structure having even in large-area size, regardless of a substrate, any desired number of layers, combination of materials, stacking angles, crystal orientation, crystal structure, and various periodic patterns or rearrangements of atoms in the in-plane direction, and having a uniform surface without defects.

Another aspect is to provide a method of preparing the moiré material based on a van der Waals stacking structure through hypotaxial growth.

Another aspect is to provide an electronic device including the moiré material based on a van der Waals stacking structure.

Additional aspects will be set forth in part in the description which follows and, in part, will be apparent from the description, or may be learned by practice of the presented embodiments of the disclosure.

According to an aspect of the disclosure, a moiré material based on a van der Waals stacking structure includes
a multi-layered thin-film structure in which each layer has an independent crystal orientation and an independent crystal structure in a vertical direction, wherein
the multi-layered thin-film structure has interference fringes of the same or different periodic patterns in a horizontal direction of a single plane, depending on a superimposed angle among layers, or shows an atomic reconstruction phenomenon in a plane.

According to another aspect of the disclosure, a method of preparing the moiré material based on a van der Waals stacking structure through hypotaxial growth, the method includes
forming a first raw material thin-film layer on at least one surface of a substrate,
arranging a two-dimensional crystalline first template on the first raw material thin-film layer,
supplying a gas supply source containing a second raw material onto the first raw material thin-film layer arranged on the two-dimensional crystalline first template, followed by performing first heat treatment, to form a crystalline first thin-film layer including a first raw material and a second raw material,
forming a third raw material thin-film layer on the crystalline first thin-film layer,
arranging a two-dimensional crystalline second template at a twisted angle on the third raw material thin-film layer, and
supplying a gas supply source containing a fourth raw material onto the third raw material thin-film layer arranged on the two-dimensional crystalline second template, followed by performing second heat treatment, to form a crystalline second thin-film layer including a third raw material and a fourth raw material,
wherein the crystalline first thin-film layer and the crystalline second thin-film layer are layers of crystals aligned through hypotaxial growth in a downward direction from the bottom of the two-dimensional crystalline first template and the bottom of the two-dimensional crystalline second template, respectively.

According to another aspect of the disclosure, an electronic device comprises
the moiré material based on a van der Waals stacking structure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic diagram illustrating a process by which a multi-layered thin-film structure of a moiré material having a van der Waals-based structure according to an embodiment is formed by using a hypotaxial growth mechanism and controlling angles;
FIG. 2A shows a diffraction pattern (left) of the surface of a MoS₂ thin film deposited by supplying reactive gas for 60 minutes during preparation of a thin-film structure of Preparation Example 1, and a transmission electron microscope (TEM) image (middle) and a diffraction pattern (right) of the surface of a MoS₂ thin film after 1^{st} hypotaxial growth by supplying reactive gas for 120 minutes during preparation of a thin-film structure of Preparation Example 1;
FIG. 2B shows results obtained by analyzing crystallinity of a MoS₂ thin film of Preparation Example 1 by using a photoluminescence spectrum;
FIG. 2C shows results of analyzing Raman spectra in a low-wavelength region (left) and a high-wavelength region (right) of a MoS₂ thin film of Preparation Example 1 when increasing the number of layers to 2, 3, and 4;
FIG. 3 is a schematic diagram illustrating a process by which a multi-layered thin-film structure of a moiré material having a van der Waals-based structure according to an embodiment is formed by controlling an angle by using a large-area transfer device;
FIG. 4 is a schematic diagram showing selected area electron diffraction (SAED) patterns and TEM images for a MoS₂/MoS₂ thin-film structure that is prepared by partially depositing a Mo thin film after 1^{st} hypotaxial growth during preparation of a thin-film structure of Example 1 and twisting the Mo thin film clockwise by about 10° and about 30° to arrange the single-crystal graphene second template, and then growing a MoS₂/MoS₂ thin-film structure thereon by 2^{nd} hypotaxy;
FIG. 5 shows a schematic view and a TEM image of MoS₂ moiré patterns in which a MoS₂/MoS₂ thin-film structure of Example 1 is prepared with a large area of about 4 inches;
FIG. 6 shows TEM images and schematic diagrams of MoS₂ moiré patterns in which MoS₂/MoS₂ thin-film structures of Examples 2 to 7 are prepared with a large area of several centimeters;
FIG. 7A shows results of analyzing Raman spectra in a low-wavelength region (left) and a high-wavelength region (right) for a MoS₂ single-crystal thin film of Preparation Example 1, a MoS₂/MoS₂ moiré thin film of Example 1, a MoS₂/2L-MoS₂ moiré thin film of Example 8, and a MoS₂/3L-MoS₂ moiré thin film of Example 9;
FIG. 7B shows results of analyzing photoluminescence spectra for a MoS₂/MoS₂ single-crystal thin film of Example 1, a MoS₂/2L-MoS₂ moiré thin film of Example 8, a MoS₂/3L-MoS₂ moiré thin film of Example 9, and a MoS₂/4L-MoS₂ moiré thin film of Example 10;
FIG. 8A shows results of analyzing Raman spectra in a low-wavelength region for a MoS₂ single-crystal thin film of Preparation Example 1, a MoS₂/MoS₂ thin film of Example 11, and a MoS₂/2L-MoS₂ thin film of Example 12;
FIG. 8B shows results of analyzing dark-field transmission electron microscope (DF-TEM) for a MoS₂/MoS₂ thin film of Example 11;
FIG. 9A shows a schematic diagram, a diffraction pattern, and a TEM image of a MoS₂ single-crystal layer of Example 13 at a clockwise twist angle (or stacking angle) during the 2^{nd} hypotaxial growth and the 3^{rd} hypotaxial growth;
FIG. 9B shows a schematic diagram showing angles (or stacking angles) at which MoS₂ layers are twisted clockwise during the 2^{nd} hypotaxial growth and the 3^{rd} hypotaxial growth when the MoS₂/MoS₂/MoS₂ super-moiré thin-film structure of Example 14 is prepared with a large area of several centimeters, and also shows optical microscope images and TEM images for the indicated area (dotted box, solid box).
FIG. 10 shows, regarding the surface of a MoS₂ single-crystal/MoS₂ polycrystal moiré domain thin-film structure of Example 15 (schematic diagram on the left), a low-magnification TEM image (in the middle) using false-color and an enlarged TEM image and a diffraction pattern (on the right) of the indicated area;
FIG. 11A shows a TEM image and a diffraction pattern for the surface of a MoS₂/WS₂ moiré thin film of Example 16;
FIG. 11B shows results of analyzing a Raman spectrum in a high-wavelength region for the surface of a MoS₂/WS₂ moiré thin film of Example 16;
FIG. 12 is a schematic diagram of a field-effect transistor (FET) according to an embodiment; and
FIG. 13 is a schematic diagram of an FET according to another embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

Hereinafter, an moiré material having a van der Waals-based stacking structure according to an embodiment of the disclosure, a method of preparing the moiré material through hypotaxial growth, and an electronic device including the moiré material will be described in greater detail with reference to the attached drawings. The following are provided as examples, and the disclosure is not limited thereto and is defined only by the scope of the claims set forth below.

Hereinafter, when a component or the like is referred to as being "above" or "on" another component, the component can be directly on the other component or above the other component in a non-contact manner.

An expression used in the singular encompasses the expression of the plural, unless it has a clearly different meaning in the context. In addition, when a portion "includes" an element, another element may be further included, rather than excluding the existence of the other element, unless otherwise described.

In the present specification, the term "combination" includes, unless otherwise described, one or more of components described herein. The terms "first," "second," "third ," "fourth ," "fifth," "sixth," "seventh," and the like may be used to describe various components, but the components should not be limited by these terms. These terms are only used to distinguish one element from another element.

In the present specification, the expression "or" includes, unless otherwise specified, the meaning of "and/or".

In the present specification, "about" or "substantially" includes a value stated herein, and also includes a value within an acceptable range of deviations of a specific value determined by those skilled in the art means in consideration of errors associated with corresponding measurement and measurement of specific quantity (i.e., the limit of the measuring system). For example, the expression "about" or "substantially" may include a value within one or more standard deviations, or a value ±30 %, ±20 %, ±10 %, or ±5 % of a specified value.

The terms "hypotaxy" and "hypotaxial" as used throughout the present specification are a combination of "hypo" and "taxy"/"taxial" meaning "downward" and "arrangement", respectively, and refer to the state of being aligned according to a crystal structure of a template in the downward direction of the template.

The term "vertical direction" as used throughout the present specification refers to the direction perpendicular to one plane and is the out-of-plane direction of growth of a thin film.

The term "horizontal direction of a single plane" as used throughout the present specification refers to the in-plane direction of growth of a thin film.

The term "van der Waals-based stacking structure" as used throughout the present specification refers to both a homostructure in which the same materials are stacked and a heterostructure in which different materials are stacked, wherein each structure is connected by the van der Waals force.

The term "a multi-layered" as used throughout the present specification refers to at least two layers.

The term "chalcogenide" as used throughout the present specification refers to a compound including one or more elements of Group 16 (chalcogens) and one or more cationic elements.

The term "diameter" as used throughout the present specification is used when referring to a "circular shape," but refers to "length of a major axis" when referring to an "elliptical shape" and "length of the long side" when referring to a "rectangular shape".

The term "moiré pattern" as used throughout the present specification is a French word meaning an interference fringe or a wave pattern, and is also referred to as a "moiré pattern". **It** refers to a new pattern that emerges when repeating simple patterns are superimposed and interfere with each other due to period differences between the patterns.

The "super-moiré pattern" as used throughout the present specification is also referred to as a moiré of moiré pattern", and is a new pattern that emerges by the interference of two or more aligned double-layer superlattices(a pair of first layer-second layer and a pair of second layer-third layer), such as a moiré period.

The "critical angle" as used throughout the present specification refers to an angle greater than 0° but equal to or less than 5°, an angle greater than 0° but equal to or less than 3°, or a near zero angle.

The term "rearrangement phenomenon of atoms" as used throughout the present specification refers to emergence of clusters of several nanometers in size that are groups of atoms that differ from the original arrangement or number of atoms.

The term "3-fold symmetry" or "6-fold symmetry" as used throughout the present specification refers to "120° rotational symmetry" or "60° rotational symmetry".

The term "moiré domain" as used throughout the present specification refers to "a region having an interference fringe of the same period in the in-plane direction of a single plane".

Throughout the present specification, the term "an embodiment" or the like means that a specific component described in connection with embodiments is included in at least one embodiment described herein, and that the specific component may or may not be present in other embodiments. In addition, components described herein should be construed as being possibly combined in any suitable manner in the various embodiments. Unless otherwise defined, all technical and scientific terms as used in the present specification have the same meaning as commonly understood by those skilled in the art to which the disclosure belongs. All patents, patent applications, and other references cited herein are incorporated by reference in their entirety. However, if any term in the present specification contradicts or conflicts with any term in the incorporated references, the term from the present specification shall control over the conflicting term in the incorporated references. While particular examples and embodiments have been described, currently unforeseen or unforeseeable alternatives, modifications, variations, improvements, and substantial equivalents may occur to applicants or those skilled in the art. Accordingly, the appended patent claims and amendments are intended to include all such alternatives, modifications, variations, improvements and substantial equivalents.

When two two-dimensional material structures are stacked, interference fringes created with different periodicities depending on a stacking angle may exhibit new physical, chemical, and electrical characteristics that are different from those of existing stacked material structures. For example, in a moiré pattern created by layering graphene and transition metal dichalcogenide (TMD), the moiré excition phenomenon has been observed. Moiré patterns have been demonstrated to have the ability to modulate superconductivity and Mott insulator states and to have ferroelectric effects.

However, two-dimensional materials used for a growth template require a transferring process, and thus there may be problems with surface uniformity and large-area growth.

The inventors of the disclosure propose the following to prepare a high-quality moiré pattern in a large scale by utilizing two-dimensional materials with various stacking angles and combinations of materials for applications in a variety of industries.

A moiré material based on a van der Waals stacking structure according to an embodiment may include a multi-layered thin-film structure in which each layer has an independent crystal orientation and an independent crystal structure in a vertical direction, the multi-layered thin-film structure having interference fringes of the same or different periodic patterns in a horizontal direction of a single plane, depending on a superimposed angle among layers, or has an atomic reconstruction phenomenon in a plane. This is supported by Evaluation Examples 1 to 7.

In the multi-layered thin-film structure according to an embodiment, materials of each layer may be the same or different materials. This is supported by Evaluation Examples 3 and 8.

The multi-layered thin-film structure according to an embodiment may include a metal chalcogenide compound, a metal oxide, a metal or metalloid carbide compound, a metal or metalloid nitride compound, or a compound thereof.

For example, the metal chalcogenide compound may include a compound represented by Formula 1:

[Formula 1] MX₂

wherein, in the formula,

M may be at least one metal or alloy selected from Nb, Mo, Tc, Ru, Rh, Pd, Ag, Cd, Hf, Ta, W, Re, Os, Ir, Pt, Au, Hg, Rf, Db, Sg, Bh, Hs, Mt, Ds, Rg, Cn, Sc, Ti, V, Cr, Mn, Fe, Co, Ni, Cu, Zn, Y, and Zr, and

X may be at least one element selected from S, Se, and Te.

For example, the compound represented by Formula 1 may include a compound represented by Formula 2:

[Formula 2] M'S₂

wherein, in the formula,
M' may be a metal selected from Nb, Mo, Tc, Ru, Rh, Pd, Ag, Cd, Hf, Ta, W, Re, Os, Ir, Pt, Au, Hg, Rf, Db, Sg, Bh, Hs, Mt, Ds, Rg, Cn, Sc, Ti, V, Cr, Mn, Fe, Co, Ni, Cu, Zn, Y, and Zr.

For example, the compound represented by Formula 1 may include MoS₂, WS₂, or a combination thereof.

For example, the metal oxide may include a transition metal oxide. Examples of the transition metal oxide may include MoO₂, WO₃, Sc₂O₃, TiO₂, V₂O₅, Cr₂O₃, Mn₃O₄, Fe₃O₄, Co₃O₄, NiO, or CuO, but embodiments are not limited thereto. Examples of the metal or metalloid carbide compound may include Al₄C₃, Mo₂C, SiC, WC, TiC, TaC, TiSiC, TaSiC, TiAlC, or TaAlC, embodiments are not limited thereto. Examples of the metal or metalloid nitride compound may include AIN, GaN, InN, TiN, TaN, or SiN, embodiments are not limited thereto. In some embodiments, the multi-layered thin-film structure may be a structure in which the metal or metalloid carbide compound and the metal or metalloid nitride compound are stacked.

The multi-layered thin-film structure according to an embodiment may have a crystal structure independent of a crystal structure or amorphous structure of the substrate. This is supported by Evaluation Example 4.

The multi-layered thin-film structure according to an embodiment may have a diameter in a range of about 1 µm to about 300 mm, embodiments are not limited thereto. This is supported by Evaluation Example 3.

Interference fringes of a periodic pattern of the multi-layered thin-film structure according to an embodiment may be a moiré pattern, a super-moiré pattern, or a combination thereof. This is supported by Evaluation Examples 3 and 6.

The atomic reconstruction phenomenon of atoms in a plane appears when the superimposed angle among layers of the multi-layered thin-film structure is at a critical angle of 5° or less. This is supported by Evaluation Example 5.

In the multi-layered thin-film structure according to an embodiment, the number of layers and the superimposed angle among layers may be controllable. This is supported by Evaluation Examples 2, 3, 4, and 6.

A method of preparing the moiré material having a van der Waals-based structure through hypotaxial growth according to an embodiment may include: forming a first raw material thin-film layer on at least one surface of a substrate; arranging a two-dimensional crystalline first template including a defective portion on the first raw material thin-film layer; supplying a gas supply source containing a second raw material onto the first raw material thin-film layer on which the two-dimensional crystalline first template is arranged, followed by performing first heat treatment, to form a crystalline first thin-film layer including a first raw material and a second raw material; forming a third raw material thin-film layer on the crystalline first thin-film layer; arranging a two-dimensional crystalline second template including a defective portion at a twisted angle on the third raw material thin-film layer; and supplying a gas supply source containing a fourth raw material onto the third raw material thin-film layer on which the two-dimensional crystalline second template is arranged, followed by performing second heat treatment, to form a crystalline second thin-film layer including a third raw material and a fourth raw material, wherein the crystalline first thin-film layer and the crystalline second thin-film layer are layers of crystals aligned through hypotaxial growth in a downward direction from the bottom of the two-dimensional crystalline first template and the bottom of the two-dimensional crystalline second template, respectively.

By the method of preparing the moiré material based on a van der Waals stacking structure through hypotaxial growth according to an embodiment, a moiré pattern having a uniform surface only by using a hypotaxial growth method that induces alignment of the crystal orientation downward by utilizing the two-dimensional crystalline template may be formed. In addition, by the method of preparing the moiré material based on a van der Waals stacking structure through hypotaxial growth according to an embodiment, a moiré pattern with a desired number of layers, a combination of material, and a stacking angle. Furthermore, by the method of preparing the moiré material based on a van der Waals stacking structure through hypotaxial growth according to an embodiment, an atomic reconstruction phenomenon that is difficult to observeduring the synthesis process. Accordingly, the method of preparing the moiré material based on a van der Waals stacking structure through hypotaxial growth according to an embodiment may be used in various applications such as manufacturing of large-area device, device array, and the like.

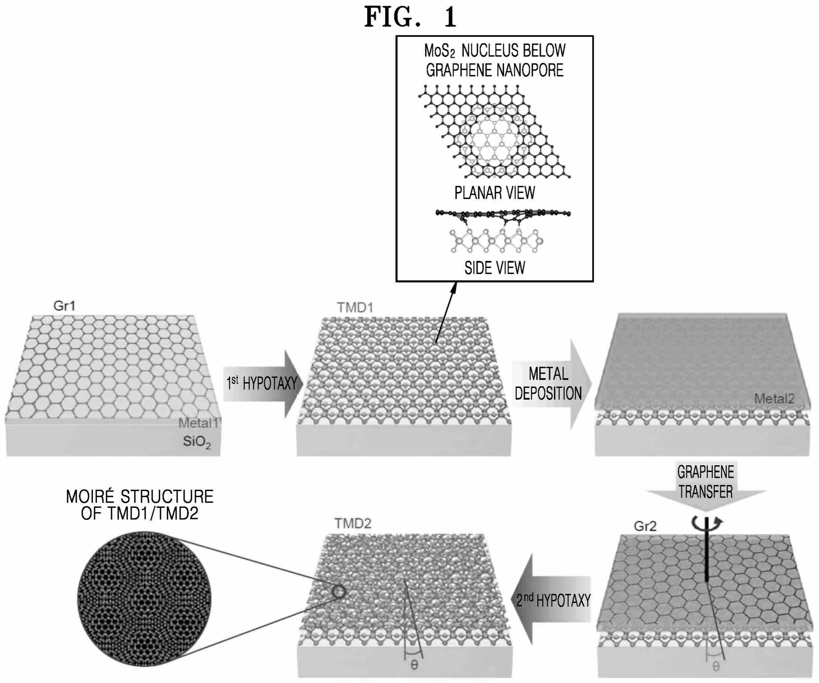

FIG. 1 is a schematic diagram illustrating a process by which a multi-layered thin-film structure of a moiré material having a van der Waals-based structure according to an embodiment is formed by using hypotaxial growth mechanism and controlling angles.

Referring to FIG. 1, a two-dimensional crystalline first template is arranged on a substrate on which a first raw material thin-film layer is arranged.

The substrate according to an embodiment may have a crystal structure or an amorphous structure. For example, the substrate may be SiO₂ or SiO₂ with an oxide film.

The first raw material thin-film layer according to an embodiment may be a metal thin-film layer or an alloy thin-film layer. The metal thin-film layer or alloy thin-film layer may include at least one metal or alloy selected from Nb, Mo, Tc, Ru, Rh, Pd, Ag, Cd, Hf, Ta, W, Re, Os, Ir, Pt, Au, Hg, Rf, Db, Sg, Bh, Hs, Mt, Ds, Rg, Cn, Sc, Ti, V, Cr, Mn, Fe, Co, Ni, Cu, Zn, Y, and Zr.

The two-dimensional crystalline first template according to an embodiment may include graphene, hexagonal boron nitride (hBN), a transition metal chalcogen compound, a graphene oxide, a metal oxide, black phosphorus, phosphorene, a polymer material, or a combination thereof. An example of the polymer material may include polymethyltetra acrylate or polydimethyl siloxane.

The two-dimensional crystalline first template according to an embodiment may have a defective portion, and the defective portion may be a vacancy or a nanopore.

The defective portion of the two-dimensional crystalline first template according to an embodiment may be formed during or in advance of the formation of a crystalline first thin-film layer.

The defective portion of the two-dimensional crystalline first template according to an embodiment may have 3-fold symmetry nanopores or 6-fold symmetry nanopores. The size of nanopores is not limited, but may be, for example, 10 nm or less or 5 nm or less.

The first raw material thin-film layer and the two-dimensional crystalline first template according to an embodiment may be formed by, although not limited thereto, physics vapor deposition (PVD), thermal deposition, electronic-beam evaporation, sputtering, chemical vapor deposition (CVD), or atomic layer deposition (ALD).

The two-dimensional crystalline first template according to an embodiment may be formed directly on the first raw material thin-film layer by the aforementioned deposition, or may be transferred and arranged on the first raw material thin-film layer.

Next, a gas supply source containing a second raw material may be applied onto the first metal thin-film layer on which the two-dimensional crystalline first template is arranged, and a first heat treatment may be accordingly performed, to form a crystalline first thin-film layer including a first raw material and a second raw material (referred to as 1^{st} hypotaxial growth).

The gas supply source containing a second raw material according to an embodiment may include one or more elements selected from S, Se, Te, C, N, and O. For example, the gas supply source containing a second raw material may include H₂S, H₂Se, H₂Te, CH₄, N₂, or O₂.

In the forming of the crystalline first thin-film layer according to an embodiment, the first heat treatment may be performed at a temperature in a range of about 200 °C to about 1100 °C for about 5 minutes to about 20 hours.

The two-dimensional crystalline first template according to an embodiment may be a sacrificial template, and the sacrificial template may be removed partially or completely.

The crystalline first thin-film layer according to an embodiment may include MoS₂, MoSe₂, MoTe₂, WS₂, WSe₂, WTe₂, In₂Se₃, Cr₂Se₃, Sb₂O₃, MoO₃, or a combination thereof.

The hypotaxial growth mechanism of the multi-layered thin-film structure according to an embodiment may be described as follows.

The crystalline first thin-film layer according to an embodiment may be formed by the nucleus (e.g., MoS₂ nucleus) of a compound forming a first thin-film layer below nanopores (e.g., 3-fold symmetry nanopores) that are defective portions of the two-dimensional crystalline first template. The crystal orientation of the nucleus may be aligned in the same direction as the crystal orientation of the two-dimensional crystalline first template by the edge of the defective portion, and the crystal structure grow while maintaining the crystal structure in a horizontal direction to the center (basal plane) of the defective portion as the reactive gas is continuously supplied. As the reactive gas is continuously supplied, the defective portion may expand, and the crystals may accordingly grow in a horizontal direction into the first thin-film layer. Here, each of the nuclei formed in the plurality of defective portions may be aligned in the same crystal orientation as the two-dimensional crystalline first template, and thus a crystalline layer thus obtained may be aligned in the same crystal orientation as the two-dimensional crystalline first template. In addition, as the reactive gas is continuously supplied, a crystalline layer abutting the bottom of the two-dimensional crystalline first template may be formed, and simultaneously or subsequently, growth in the downward direction of the formed crystalline layer may also occur. Then, consequently, a multi-layered crystalline thin film aligned in the same crystal orientation as the two-dimensional crystalline first template may be formed.

That is, the crystalline first thin-film layer according to an embodiment may be converted into a first crystalline thin-film layer having the same crystal structure as the crystal structure of single crystals or polycrystals at the bottom of the two-dimensional crystalline first template, regardless of a crystalline structure of a substrate.

Next, a third raw material thin-film layer may be formed on the crystalline first thin-film layer. A material, a thickness, and a formation method of the third raw material thin-film layer may be the same as those of the aforementioned first raw material thin-film layer, and thus descriptions thereof are omitted.

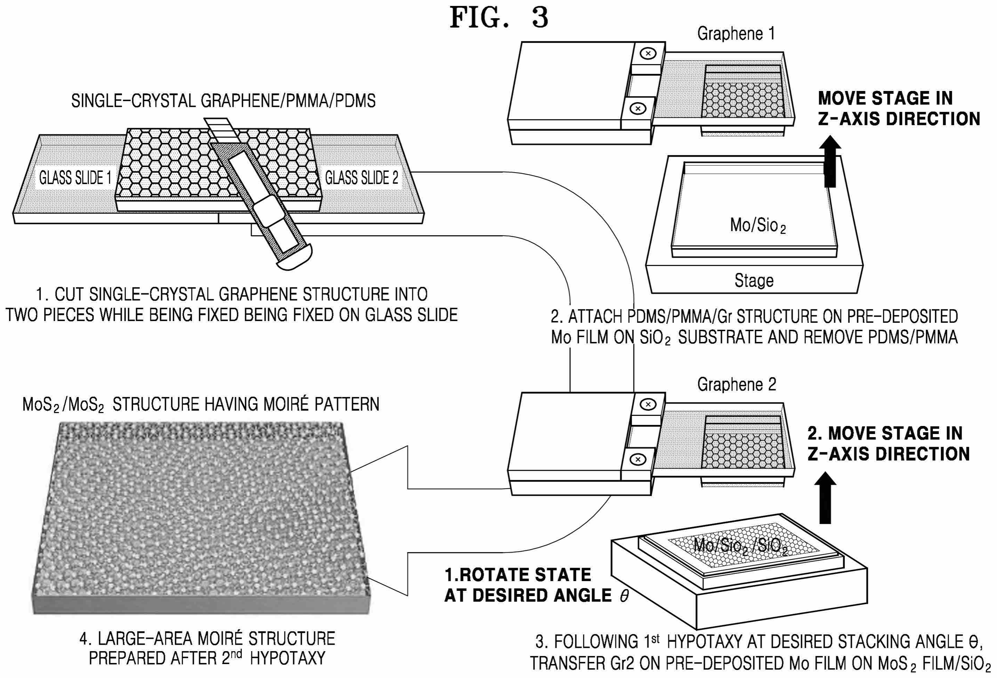

Next, the two-dimensional crystalline second template including a defective portion may be arranged at a twisted angle on the third raw material thin-film layer. The formation method of the two-dimensional crystalline second template including a defective portion is the same as that of the two-dimensional crystalline second template, and thus a description thereof will be omitted. To arrange the two-dimensional crystalline second template at a precisely controlled angle on the third raw material thin-film layer, a large-area transfer apparatus of FIG. 3 which will be described below is used. The large-area transfer apparatus of FIG. 3 enable to move a stage to transfer the two-dimensional crystalline first template and the two-dimensional crystalline second template onto a thin-film structure, and the stage is rotatable so that the two-dimensional crystalline first template and the two-dimensional crystalline second template may be precisely controlled at a desired angle.

For example, in an embodiment where both the two-dimensional crystalline first template and the two-dimensional crystalline second template are graphene and the thin-film layer is MoS₂, referring to FIG. 3, a graphene template/PMMA/PDMS structure is cut into a desired number of layers (e.g., 2 or more layers) and prepared (1^{st} process). The prepared graphene template/PMMA/PDMS structure is attached on a SiO₂/Mo thin-film structure by moving the rotatable stage in the z-axis direction, and the PMMA/PDMS is peeled off and the 1^{st} hypotaxial growth is allowed thereon, thereby preparing a SiO₂/MoS₂ thin film structure (2^{nd} process). After the rotatable stage is rotated at a desired angle, the prepared graphene template/PMMA/PDMS structure is attached and the PMMA/PDMS is peeled off. The 2^{nd} hypotaxial growth is allowed accordingly, thereby preparing a MoS₂/MoS₂ thin film structure having a moiré pattern (3^{rd} process and 4^{th} process).

Next, a gas supply source containing a fourth raw material is applied onto the third raw material thin-film layer on which the two-dimensional crystalline second template is arranged, and second heat treatment is performed to form a crystalline second thin-film layer including a third raw material and a fourth raw material, thereby completing the preparation of the multi-layered thin-film structure. The gas supply source containing a fourth raw material is the same as the gas supply source containing a second raw material, and thus a description thereof will be omitted.

The aforementioned crystalline first thin-film layer and the crystalline second thin-film layer may be layers of crystals aligned through hypotaxial growth in a downward direction from the bottom of the two-dimensional crystalline first template and the bottom of the two-dimensional crystalline second template, respectively.

Another aspect provides an electronic device including the moiré material based on a van der Waals stacking structure.

The electronic device according to an embodiment may be a field-effect transistor (FET), a memory device, a PN junction device, a neuromorphic device, an exciton device, or a quantum device. The electronic device may be applied to quantum computing, artificial intelligence, quantum communication, and the like.

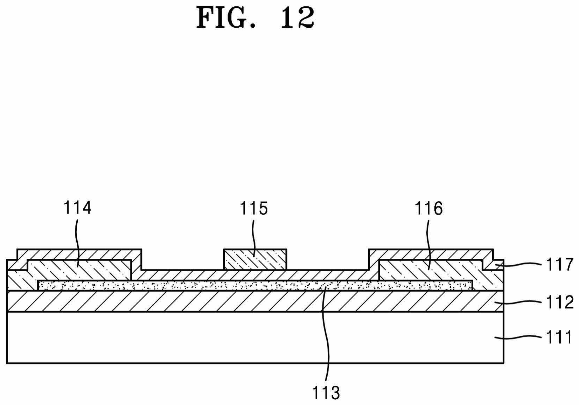

FIG. 12 is a schematic diagram of an FET according to an embodiment.

Referring to FIG. 12, a silica substrate 112 is on a substrate 111, and the aforementioned multi-layered thin-film structure having a heterostructure is placed as a channel layer 113 on the silica substrate 112. On the left and right of the channel layer 113, a source electrode 114 and a drain electrode 116 are placed, and a gate electrode 115 is placed on an insulator layer 117 such that the insulator layer 117 is placed between the gate electrode 115 and the channel layer 113. Here, by applying voltage to the gate electrode 115, the current flowing between the source electrode 114 and the drain electrode 116 may be controlled. That is, the multi-layered thin-film structure includes a channel region, and is configured to perform an on/off operation by controlling the current flowing between the source electrode 114 and the drain electrode 116 by the voltage applied to the gate electrode 115.

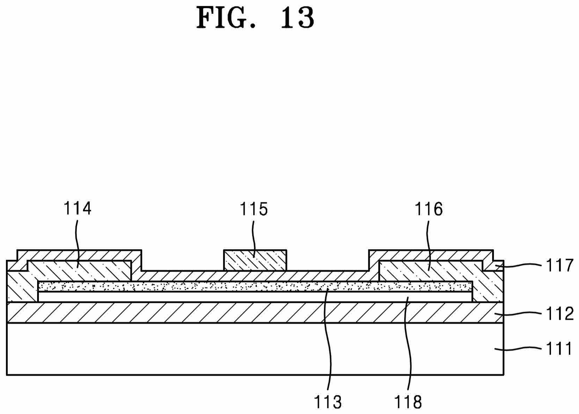

FIG. 13 is a schematic diagram of an FET according to another embodiment.

Referring to FIG. 13, for the purpose of controlling scattering of charges in the multi-layered thin-film structure having the heterostructure, i.e., the channel layer 113, caused by the roughness of the surface of the silica substrate 112 and the dangling bonds, upon movement, a buffer layer 118 may be placed between the channel layer 113 and the silica substrate 112. For use as the buffer layer 118, the multi-layered thin-film structure may be also used.

In one or more embodiments, for the purpose of enhancing injection efficiency, a buffer layer (not shown) may be placed between the channel layer 113 and the insulator layer 117. Here, for use as the buffer layer, the multi-layered thin-film structure may be used.

Another aspect provides an optical device including the moiré material based on a van der Waals stacking structure.

The optical device according to an embodiment may be a light-detecting optical device having circular chirality.

Hereinafter, Examples and Comparative Examples of the disclosure will be described. However, Examples below are only examples of the disclosure, and the disclosure is not limited thereto.

### [Examples]

### Synthesis Example 1: Single-crystal graphene template

A single-crystal graphene template was synthesized by supplying methane gas and hydrogen gas at flow rates of 1 sccm and 100 sccm, respectively, onto a single-crystal copper foil (manufactured by Alfa Aesar) under a vacuum atmosphere using a CVD system, and performing heat treatment at 1050 °C for 30 minutes.

### Synthesis Example 2: Polycrystal graphene template

A polycrystal graphene template was synthesized in the same manner as in Synthesis Example 1, except that a polycrystal copper foil (manufactured by Wieland) was used instead of the single-crystal copper foil and that methane gas and hydrogen gas were applied at flow rates of 1 sccm and 100 sccm, respectively.

### Synthesis Example 3: Single crystal graphene template/PMMA/PDMS structure

A single-crystal graphene template/PMMA/PDMS structure was prepared by coating the single-crystal graphene template of Synthesis Example 1 sequentially thinly with polymethyl methacrylate (PMMA) and polydimethyl siloxane (PDMS) and cutting the coated single-crystal graphene template into a predetermined number of pieces while the coated single-crystal graphene template was fixed on a glass slide.

### Synthesis Example 4: Polycrystal graphene template/PMMA/PDMS structure

A polycrystal graphene template/PMMA/PDMS structure cut into a predetermined number of pieces was prepared in the same manner as in Synthesis Example 3, except that the polycrystal graphene template of Synthesis Example 2 was used instead of the single-crystal graphene template of Synthesis Example 1.

### Preparation Example 1: MoS₂ single-crystal thin film structure through hypotaxial growth

A MoS₂ single-crystal thin film structure through hypotaxial growth was prepared as follows.

A SiO₂ substrate (thickness: 285 nm) including an oxide film was prepared. A sample was prepared by depositing a Mo thin film on the substrate by electronic-beam evaporation and transferring the MO thin film onto the single-crystal graphene template of Synthesis Example 1. The prepared sample was placed into a reaction chamber of a vertical CVD system. Here, the pressure inside the reaction chamber was adjusted to be in a range of about 10⁻³ Torr to about 760 Torr (normal pressure). After raising the temperature inside of the reaction chamber to 1,000 °C at a rate of 15 °C/min, a reaction was conducted by supplying argon (Ar) gas and hydrogen sulfide (H₂S) gas at flow rates of 130 sccm and 20 sccm, respectively. After the reaction was completed after about 120 minutes, a MoS₂ single-crystal thin film structure in which the MoS₂ single-crystal thin film was deposited on the SiO₂ substrate including an oxide film.

### Preparation Example 2: MoS₂ polycrystal thin film structure through hypotaxial growth

A MoS₂ polycrystal thin film structure was prepared in the same manner as in Preparation Example 1, except that a sample was prepared by using the polycrystal graphene template of Synthesis Example 2 instead of the single-crystal graphene template of Synthesis Example 1.

### Example 1: MoS₂/MoS₂ moiré thin-film structure

A MoS₂/MoS₂ moiré thin-film structure was prepared on a substrate as follows in the order of FIG. 3.

A SiO₂/Mo thin-film structure was prepared by depositing a molybdenum (Mo) thin film (thickness: about 0.3 nm) on a SiO₂ substrate (thickness: 285 nm) including a oxide film by electronic-beam evaporation. After the SiO₂/Mo thin-film structure was placed on a rotatable stage, the rotatable state was moved in the z-axis, and the single-crystal graphene template/PMMA/PDMS structure of Synthesis Example 3 was then attached on the Mo thin film. The PMMA/PDMS on the single-crystal graphene template structure was peeled off, and a SiO₂/Mo thin film/single-crystal graphene first template structure was prepared accordingly.

By using the prepared structure as a sample, a MoS₂ single-crystal thin-film structure was prepared by the hypotaxial growth as described in Preparation Example 1 (after the 1^{st} hypotaxial growth).

Subsequently, a SiO₂/MoS₂/Mo thin-film structure was prepared by depositing a Mo thin film (thickness: about 0.5 nm) on the MoS₂ single-crystal thin-film structure by electronic-beam evaporation. The stage was rotated clockwise by an angle of about 8° and moved in the z-axis direction, and the single-crystal graphene template/PMMA/PDMS structure of Synthesis Example 3 was then attached. The PMMA/PDMS on the single-crystal graphene template was peeled off, and a SiO₂/MoS₂/Mo thin film/single-crystal graphene second template structure was prepared accordingly.

By using the prepared structure as a sample, a MoS₂/MoS₂ moiré thin-film structure was prepared on a substrate by the hypotaxial growth as described in Preparation Example 1 (after the 2^{nd} hypotaxial growth).

### Examples 2 to 7 : MoS₂/MoS₂ moiré thin-film structure

MoS₂/MoS₂ moiré thin-film structures were each prepared in the same manner as in Example 1, except that, after preparing the SiO₂/MoS₂/Mo thin-film structure, the stage was rotated clockwise by an angle of about 9°, 10°, 12°, 14°, 20°, and 23°, respectively, clockwise, and then moved in the z-axis direction to attach the single-crystal graphene template/PMMA/PDMS structure of Synthesis Example 3.

### Example 8: MoS₂/2LMoS₂ moiré thin-film structure

A SiO₂/MoS₂/MoS₂/Mo thin-film structure in which a Mo thin film (thickness: about 0.8 nm) was deposited by electronic-beam evaporation on the MoS₂/MoS₂ moiré thin-film structure formed on the substrate of Example 1 was prepared. The stage was moved in the z-axis direction to attach the single-crystal graphene template/PMMA/PDMS structure of Synthesis Example 3. The PMMA/PDMS on the single-crystal graphene template was peeled off, and a SiO₂/MoS₂/MoS₂/Mo thin film/single-crystal graphene third template structure was prepared accordingly.

By using the prepared structure as a sample, a MoS₂/2LMoS₂ (where 2L represents 2 layers) moiré thin-film structure was prepared by the hypotaxial growth as described in Preparation Example 1 (after the 3^{rd} hypotaxial growth).

### Example 9: MoS₂/3LMoS₂ moiré thin-film structure

A SiO₂/MoS₂/2LMoS₂/Mo thin-film structure in which a Mo thin film (thickness: about 1.1 nm) was deposited by electronic-beam evaporation on the MoS₂/2LMoS₂ (where 2L represents 2 layers) moiré thin-film structure formed on the substrate of Example 8 was prepared. The stage was moved in the z-axis direction to attach the single-crystal graphene template/PMMA/PDMS structure of Synthesis Example 3. The PMMA/PDMS on the single-crystal graphene template was peeled off, and a SiO₂/MoS₂/MoS₂/Mo thin film/single-crystal graphene fourth template structure was prepared accordingly.

By using the prepared structure as a sample, a MoS₂/3LMoS₂ (where 3L represents 3 layers) moiré thin-film structure was prepared by the hypotaxial growth as described in Preparation Example 1 (after the 4^{rd} hypotaxial growth).

### Example 10: MoS₂/4LMoS₂ moiré thin-film structure

SiO₂/MoS₂/3LMoS₂/Mo thin-film structure in which a Mo thin film (thickness: about 1.4 nm) was deposited by electronic-beam evaporation on the MoS₂/3LMoS₂ (where 3L represents 3 layers) moiré thin-film structure formed on the substrate of Example 9 was prepared. The stage was moved in the z-axis direction to attach the single-crystal graphene template/PMMA/PDMS structure of Synthesis Example 3. The PMMA/PDMS on the single-crystal graphene template was peeled off, and a SiO₂/MoS₂/MoS₂/MoS₂/Mo thin film/single-crystal graphene fifth template structure was prepared accordingly.

By using the prepared structure as a sample, a MoS₂/4LMoS₂ (where 4L represents 4 layers) moiré thin-film structure was prepared by the hypotaxial growth as described in Preparation Example 1 (after the 5^{th} hypotaxial growth).

### Example 11: MoS₂/MoS₂ thin-film structure

A MoS₂/MoS₂ thin-film structure was prepared in the same manner as in Example 1, except that, after preparing the SiO₂/MoS₂/Mo thin-film structure, the stage was rotated clockwise by an angle greater than 0° and equal to or less than 2° (critical angle), and then moved in the z-axis direction to attach the single-crystal graphene template/PMMA/PDMS structure of Synthesis Example 3.

### Example 12: MoS₂/2L-MoS₂ thin-film structure

A SiO₂/MoS₂/MoS₂/Mo thin-film structure in which a Mo thin film (thickness: about 0.5 nm) was deposited by electronic-beam evaporation on the MoS₂/MoS₂ thin-film structure of Example 11 was prepared. The stage was moved in the z-axis direction to attach the single-crystal graphene template/PMMA/PDMS structure of Synthesis Example 3. The PMMA/PDMS on the single-crystal graphene template was peeled off, and a SiO₂/MoS₂/MoS₂/Mo thin film/single-crystal graphene third template structure was prepared accordingly.

By using the prepared structure as a sample, a MoS₂/2L-MoS₂ (where 2L represents 2 layers) thin-film structure was prepared by the hypotaxial growth as described in Preparation Example 1 (after the 3^{rd} hypotaxial growth).

### Example 13: MoS₂/MoS₂/MoS₂ super-moiré thin-film structure

A SiO₂/MoS₂/Mo thin-film structure in which a Mo thin film (thickness: about 0.5 nm) was deposited by electronic-beam evaporation on the MoS₂/MoS₂ moiré thin-film structure formed on the substrate of Example 1 was prepared. The stage was rotated clockwise by an angle of about 15° and moved in the z-axis direction, and the single-crystal graphene template/PMMA/PDMS structure of Synthesis Example 3 was then attached. The PMMA/PDMS on the single-crystal graphene template was peeled off, and a SiO₂/MoS₂/Mo thin film/single-crystal graphene second template structure was prepared accordingly.

By using the prepared structure as a sample, a MoS₂/MoS₂ moiré thin-film structure was prepared by the hypotaxial growth as described in Preparation Example 1 (after the 2^{nd} hypotaxial growth).

Subsequently, a SiO₂/MoS₂/MoS₂/Mo thin-film structure was prepared by depositing a Mo thin film (thickness: about 0.5 nm) on the MoS₂/MoS₂ moiré thin-film structure by electronic-beam evaporation. The stage was additionally rotated clockwise by an angle of about 30° and moved in the z-axis direction, and the single-crystal graphene template/PMMA/PDMS structure of Synthesis Example 3 was then attached. The PMMA/PDMS on the single-crystal graphene template was peeled off, and a SiO₂/MoS₂/MoS₂/Mo thin film/single-crystal graphene third template structure was prepared accordingly.

By using the prepared structure as a sample, a MoS₂/MoS₂/MoS₂ super-moiré thin-film structure was prepared on a substrate by the hypotaxial growth as described in Preparation Example 1 (after the 3^{rd} hypotaxial growth).

### Example 14: MoS₂/MoS₂/MoS₂ super-moiré thin-film structure

Following the 1^{st} post-hypotaxial growth of Example 1, the SiO₂/MoS₂/Mo thin-film structure was prepared, and the state was twisted clockwise by an angle of about 10° to prepare a MoS₂/MoS₂ moiré thin-film structure by the hypotaxial growth as described in Preparation Example 1 (after the 2^{nd} hypotaxial growth).

Subsequently, a MoS₂/MoS₂/MoS₂ super-moiré thin-film structure was prepared in the same manner as in Example 13, except that, after preparing the SiO₂/MoS₂/MoS₂/Mo thin-film structure, the stage was additionally twisted clockwise by an angle of about 26° (after the 3^{rd} hypotaxial growth).

### Example 15: MoS₂ single-crystal /MoS₂ polycrystal moiré domain thin-film structure

Following the 1^{st} post-hypotaxial growth of Example 1, the SiO₂/MoS₂/Mo thin-film structure in which a Mo thin film (thickness: about 0.5 nm) was deposited by electronic-beam evaporation on the SiO₂/MoS₂ single-crystal thin-film structure formed on the substrate of Example 1 was prepared. The stage was rotated clockwise by an angle of about 15° and moved in the z-axis direction, and the polycrystal graphene template/PMMA/PDMS structure of Synthesis Example 4 was then attached. The PMMA/PDMS on the polycrystal graphene template was peeled off, and a SiO₂/MoS₂ single-crystal/Mo thin film/polycrystal graphene second template structure was prepared accordingly.

By using the prepared structure as a sample, a MoS₂ single-crystal/MoS₂ polycrystal moiré thin-film structure was prepared by the hypotaxial growth as described in Preparation Example 1 (after the 2^{nd} hypotaxial growth).

### Example 16: MoS₂/WS₂ moiré thin-film structure

A SiO₂/WS₂/Mo thin-film structure was prepared by depositing a Mo thin film (thickness: about 1 nm) on a SiO₂/WS₂ single-crystal thin-film structure that was prepared by depositing a W thin film (1 nm) instead of the Mo thin film during the 1^{st} hypotaxial growth of Example 1. The stage was rotated clockwise by an angle of about 11° and moved in the z-axis direction, and the single-crystal graphene template/PMMA/PDMS structure of Synthesis Example 3 was then attached. The PMMA/PDMS on the single-crystal graphene template was peeled off, and a SiO₂/WS₂/Mo thin film/single-crystal graphene second template structure was prepared accordingly.

By using the prepared structure as a sample, a WS₂/MoS₂ moiré thin-film structure was prepared on a substrate by the hypotaxial growth as described in Preparation Example 1 (after the 2^{nd} hypotaxial growth).

### Evaluation Example 1: Thin-film characteristics of MoS₂ of Preparation Example 1 (1)- Single-crystal, presence of surface defects

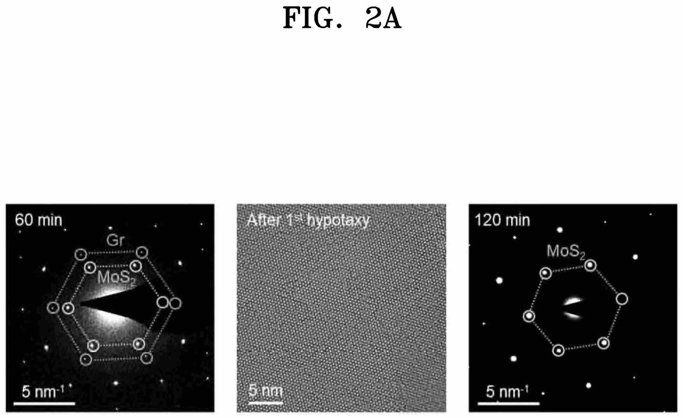

To observe the formation process of the MoS₂ of Preparation Example 1 and confirm whether the thin film has monocrystalline after the 1^{st} hypotaxial growth, diffraction patterns and transmission electron microscope (TEM) images of each MoS₂ surface formed when the reaction was conducted for 60 minutes and 120 minutes while supplying the reactive gas were photographed. The results are shown in FIG. 2A.

FIG. 2A shows a diffraction pattern (left) of the surface of the MoS₂ thin film deposited by supplying reactive gas for 60 minutes during the preparation of the thin-film structure of Preparation Example 1, and a TEM image (middle) and a diffraction pattern (right) of the surface of the MoS₂ thin film after the 1^{st} hypotaxial growth by supplying reactive gas for 120 minutes during the preparation of the thin-film structure of Preparation Example 1.

Referring to FIG. 2A, the surface of the MoS₂ thin film of Preparation Example 1 deposited by supplying reactive gas for 60 minutes was before the graphene template was completely removed, and some of the graphene template could be observed on the sample surface. Accordingly, it was confirmed that all the deposited MoS₂ nuclei had a single-crystal structure of which the crystal orientation consists with that of the graphene template.

In addition, referring to the TEM image of the surface of the MoS₂ thin film after the end of the 1^{st} hypotaxial growth by supplying reactive gas for 120 minutes in Preparation Example 1, the TEM image was clean and free of defects, with no graphene template present.

The MoS₂ thin film of Preparation Example 1 was grown, regardless of the structure of the substrate, as a single-crystal layer identical to the graphene template. The graphene template on the MoS₂ thin film of Preparation Example 1 was naturally removed during the reaction.

### Evaluation Example 2: Thin-film characteristics of MoS₂ of Preparation Example 1 (2)- Crystallinity, control of number of layers

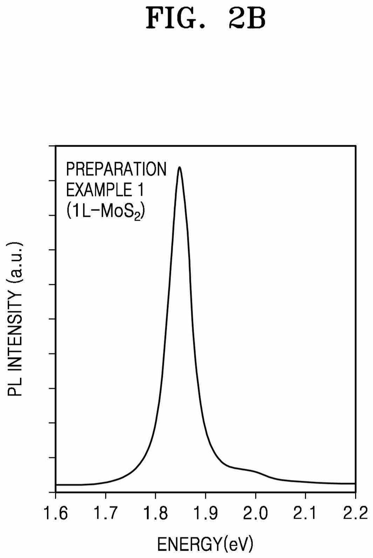

The crystallinity of the MoS₂ thin film of Preparation Example 1 was analyzed based on a photoluminescence spectrum. The results are shown in FIG. 2B.

Referring to FIG. 2B, the MoS₂ thin film of Preparation Example 1 showed high crystallinity with a narrow half-width and a strong peak intensity in the energy range between 1.8 eV and 1.9 eV.

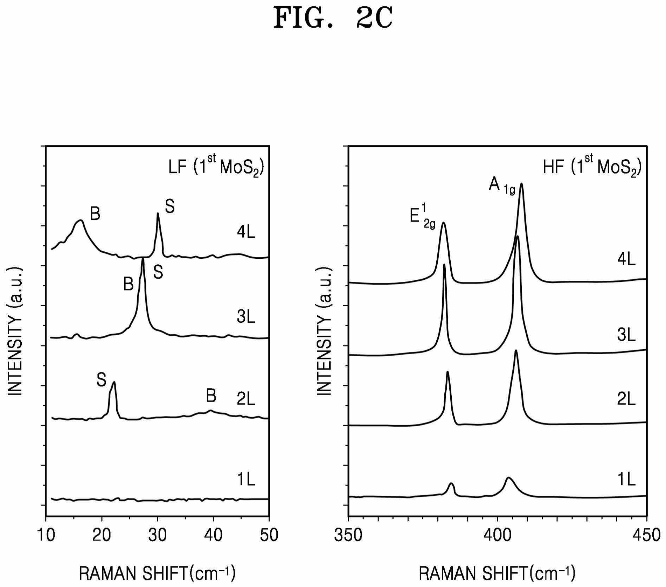

In addition, the Raman spectra in the low-wavelength region (left) and high-wavelength region (right) of the MoS₂ thin film of Preparation Example 1 were analyzed when increasing the number of layers to 2, 3, and 4. The results are shown in FIG. 2C.

The Raman spectra in the low-wavelength region (left) showed the stacking method of the multi-layered thin-film structure and the stacking order of materials in each layer. Here, B represents breathing motion, and S represents shear motion. The Raman spectrum in the high-wavelength region (right) showed changes depending on the number of layers in the multi-layered thin-film structure. Here, peaks appear at about 382 cm⁻¹ in the E¹_{2g} mode, and peaks appear at about 408 cm⁻¹ in the A_{1g} mode.

Referring to FIG. 2C, according to the Raman spectrum in the low-wavelength region (left), in the MoS₂ thin film prepared by the hypotaxial growth in Preparation Example 1, peaks in the breathing motion disappeared at about 41 cm⁻¹ and peaks in the breathing motion appeared at about 12 cm⁻¹ (blue shift), as the number of layers increased. In the MoS₂ thin film prepared by the hypotaxial growth in Preparation Example 1, peaks in the shear motion disappeared at about 22 cm⁻¹ and peaks in the shear motion appeared at about 32 cm⁻¹ (red shift), as the number of layers increased. According to the Raman spectrum in the high-wavelength region (right), the distance between peaks in the E¹_{2g} mode and peaks in the A_{1g} mode increased in the MoS₂ thin film prepared by the hypotaxial growth in Preparation Example 1, as the number of layers increased.

Accordingly, it was confirmed that the MoS₂ thin film of Preparation Example 1 had the Raman spectrum modified according to the increase in the number of layers and that the number of layers could be precisely controlled.

### Evaluation Example 3: Thin-film characteristics of MoS₂ of Examples 1 to 7- Moiré pattern, large-area uniformity, angle control

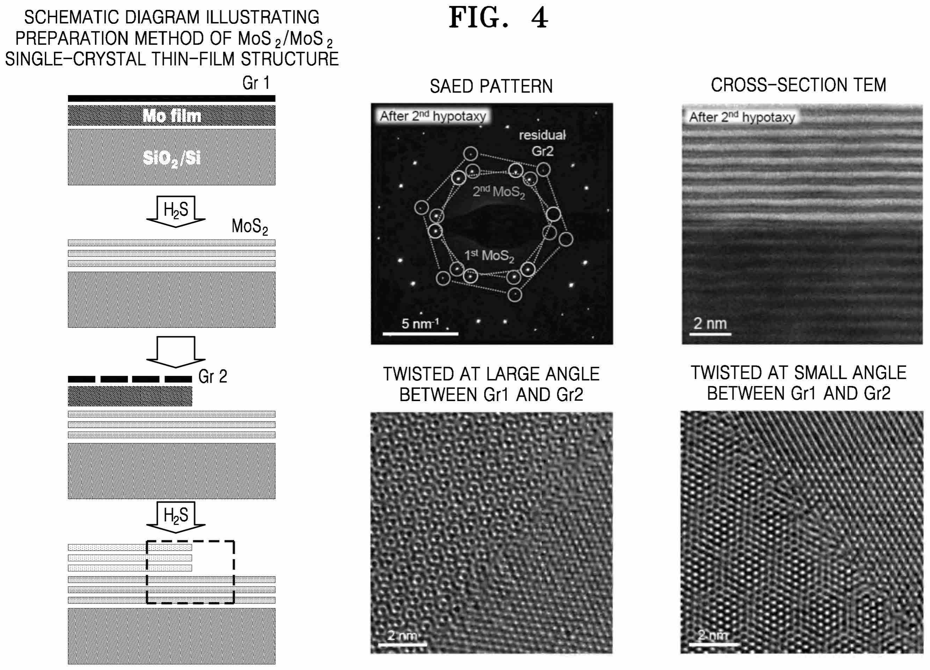

In the preparation of the thin-film structure of Example 1, the Mo thin film was partially deposited after the 1^{st} hypotaxial growth and then twisted clockwise by about 10° and about 30° to arrange the single-crystal graphene second template, and the MoS₂/MoS₂ thin-film structure underwent the 2^{nd} hypotaxial growth on the single-crystal graphene second template. For the MoS₂/MoS₂ thin-film structure, selected area electron diffraction (SAED) patterns and TEM images were obtained (see the left schematic diagram in FIG. 4, dotted line). To confirm the crystal orientation of the MoS₂ nucleus grown by the 1^{st} hypotaxy and the crystal orientation of the MoS₂ nucleus grown by the 2^{nd} hypotaxy, some of the graphene template were left during the 2^{nd} hypotaxial growth. The results are shown in FIG. 4.

Referring to the SAED pattern of FIG. 4, it was confirmed that the crystal orientation of the 1^{st} MoS₂ nucleus grown by the 1^{st} hypotaxy had a single-crystal structure that matched the graphene template. It was also confirmed that the crystal orientation of the 2^{nd} MoS₂ nucleus grown by the 2^{nd} hypotaxy was twisted clockwise by about 10° but had a single-crystal structure that matched the graphene template.

Referring to the TEM images of FIG. 4, it was confirmed through the cross section of the dotted line portion of the MoS₂/MoS₂ thin-film structure grown by the 2^{nd} hypotaxy that the boundary between moiré patterns and MoS₂ single crystals was clear. In addition, through the surface of the dotted line portion of the MoS₂/MoS₂ thin-film structure grown by the 2^{nd} hypotaxy, clean moiré patterns without any polymer contamination or interlayer bubbles and the surface on which MoS₂ single crystals were formed could be observed regardless of the twisted angle.

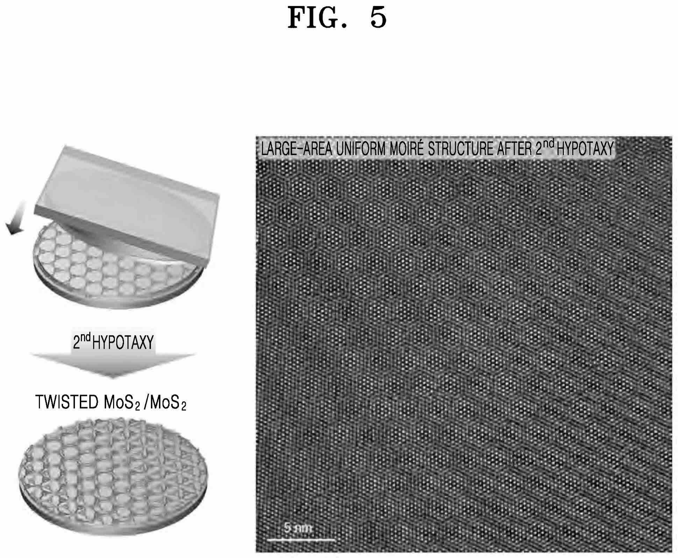

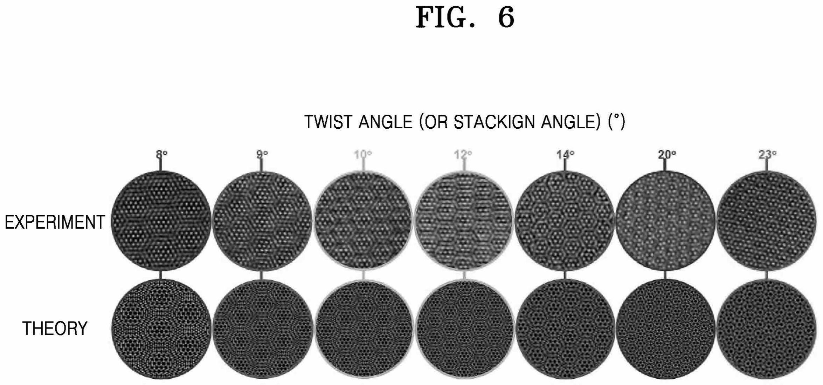

In addition, TEM images of moiré patterns were photographed on the MoS₂/MoS₂ thin-film structures Examples 1 to 7 prepared with a large area of about 4 inches (inch) to several centimeters (cm). The results are shown in FIGS. 5 and 6.

FIG. 5 shows a schematic view and a TEM image of MoS₂ moiré patterns in which the MoS₂/MoS₂ thin-film structure of Example 1 was prepared with a large area of about 4 inch. FIG. 6 shows TEM images and schematice diagrams of MoS₂ moiré patterns in which the MoS₂/MoS₂ thin-film structures of Examples 2 to 7 were prepared with a large area of several centimeters.

Referring to FIGS. 5 and 6, it was confirmed that, even when the MoS₂/MoS₂ thin-film structures of Examples 1 to 7 were prepared with a large area, not only were moiré patterns uniformly formed, but also various periods of the moiré patterns were confirmed.

Accordingly, it was confirmed that, regarding the uniformity not achieved through the moiré patterns by the existing transfer method, the MoS₂/MoS₂ thin-film structure of Example 1 could prepare moiré patterns uniformly in a large area only by synthesis without any polymer contamination or bubbles. Through the TEM images of the MoS₂/MoS₂ thin-film structures of Examples 2 to 7, it was confirmed that moiré patterns, which are interference fringes that allow precise control of the interlayer stacking angles of the MoS₂ and have a period varying with angles, could be implemented.

### Evaluation Example 4: Thin-film characteristics of MoS₂ of Examples 1, 8, 9, and 10- Control of number of layers based on 2^{nd} hypotaxial growth, crystallinity

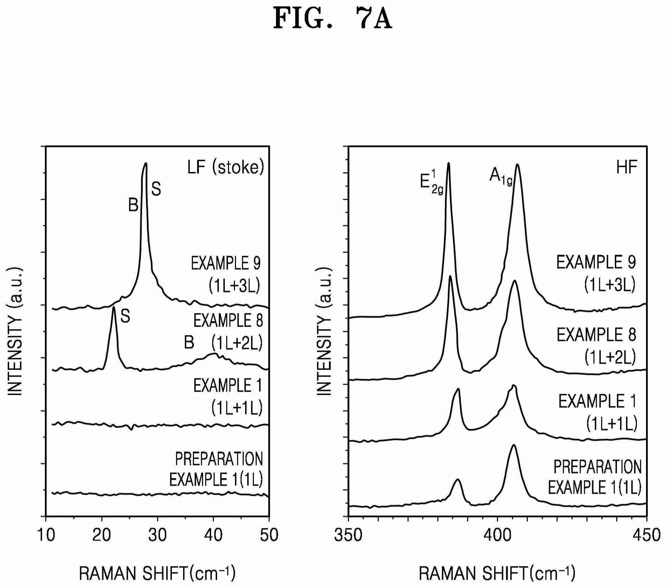

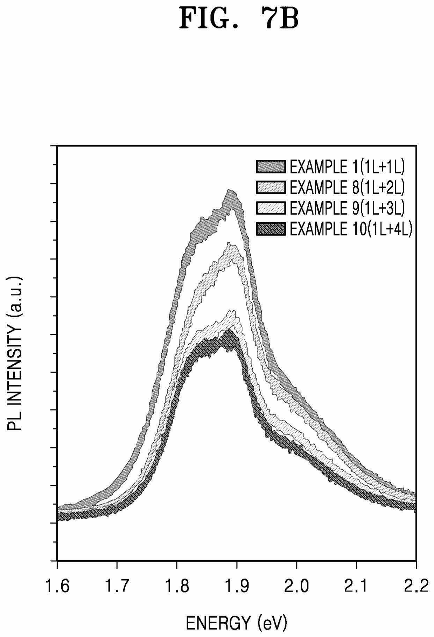

Regarding the MoS₂ single-crystal thin film of Preparation Example 1, the MoS₂/MoS₂ moiré thin film of Example 1, the MoS₂/2LMoS₂ moiré thin film of Example 8, the MoS₂/3LMoS₂ moiré thin film of Example 9, and the MoS₂/4LMoS₂ moiré thin film of Example 10, the Raman spectra and photoluminescence spectra in the low-wavelength region (left) and high-wavelength region (right) were analyzed. The results are shown in FIGS. 7A and 7B.

Referring to FIG. 7A, the MoS₂/MoS₂ moiré thin film of Example 1, the MoS₂/2LMoS₂ moiré thin film of Example 8, and the MoS₂/3LMoS₂ moiré thin film of Example 9 exhibited modified Raman spectra different from the Raman spectrum of the MoS₂ single-crystal thin film of Preparation Example 1. In detail, the MoS₂/MoS₂ moiré thin film of Example 1, the MoS₂/2LMoS₂ moiré thin film of Example 8, and the MoS₂/3LMoS₂ moiré thin film of Example 9 exhibited, regardless of the MoS₂ grown by the 1^{st} hypotaxy, modified Raman spectra for the MoS₂, 2LMoS₂, and 3LMoS₂ (wherein L represents (number of) layers) grown by the 2^{nd} hypotaxy, and the distance between the peaks in the E¹_{2g} mode and the A_{1g} mode increased as the number of layers increased.

Regarding FIG. 7B, as the number of layers increased, the MoS₂/MoS₂ moiré thin film of Example 1, the moiré MoS₂/2LMoS₂ thin film of Example 8, the MoS₂/3LMoS₂ moiré thin film of Example 9, and the MoS₂/4LMoS₂ moiré thin film of Example 10 exhibited high crystallinity with a narrow half-width and strong intensity of peaks in the energy range between 1.8 eV and 1.9 eV.

In this regard, it was confirmed that the MoS₂/MoS₂ moiré thin film of Example 1, the MoS₂/2LMoS₂ moiré thin film of Example 8, the MoS₂/3LMoS₂ moiré thin film of Example 9, and the MoS₂/4LMoS₂ moiré thin film of Example 10 that have the moiré patterns exhibited new thin film characteristics different from the MoS₂ single-crystal thin film of Preparation Example 1.

### Evaluation Example 5: Thin-film characteristics of MoS₂ of Examples 11 and 12-Rearrangement phenomenon of atoms

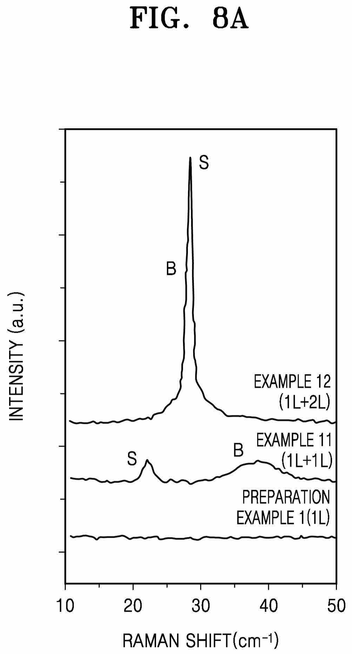

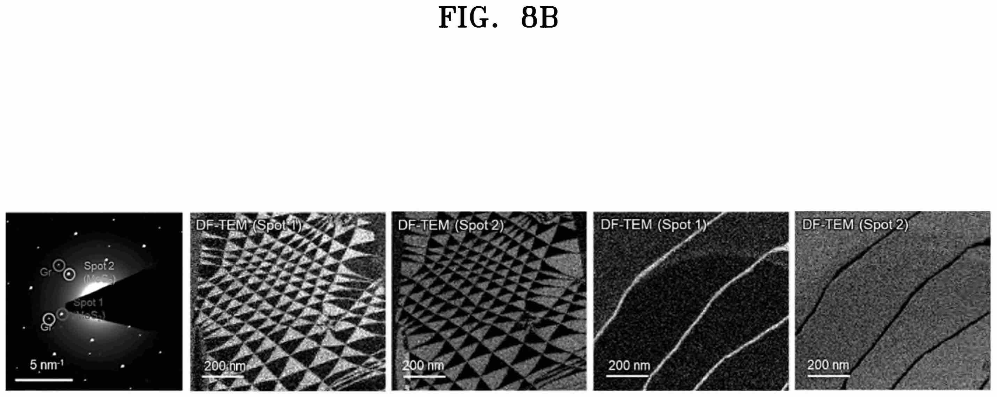

Regarding the MoS₂ single-crystal thin film of Preparation Example 1, the MoS₂/MoS₂ thin film of Example 11, and the MoS₂/2LMoS₂ thin film of Example 12, the Raman spectra in the low-wavelength region and dark-field transmission electron microscope (DF-TEM) were analyzed. The results are shown in FIGS. 8A and 8B.

Referring to FIG. 8A, the MoS₂/MoS₂ thin film of Example 11 and the MoS₂/2LMoS₂ thin film of Example 12 exhibited modified Raman spectra different from the Raman spectrum of the MoS₂ single-crystal thin film of Preparation Example 1. In detail, the MoS₂/2LMoS₂ thin film of Example 12 exhibited a 3R stacking order, unlike the MoS₂/MoS₂ thin film (2H stacking layer) of Example 11.

Referring to FIG. 8B, in the MoS₂/MoS₂ thin film of Example 11, the atomic reconstruction phenomenon was observed in which atoms were reconstructed by moving at a small stacking angle through the AB domain and the BA domain and become energetically more stable.

### Evaluation Example 6: Thin-film characteristics of MoS₂/MoS₂/MoS₂ of Examples 13 and 14- Super-moiré patterns, large-area uniformity, control of angles

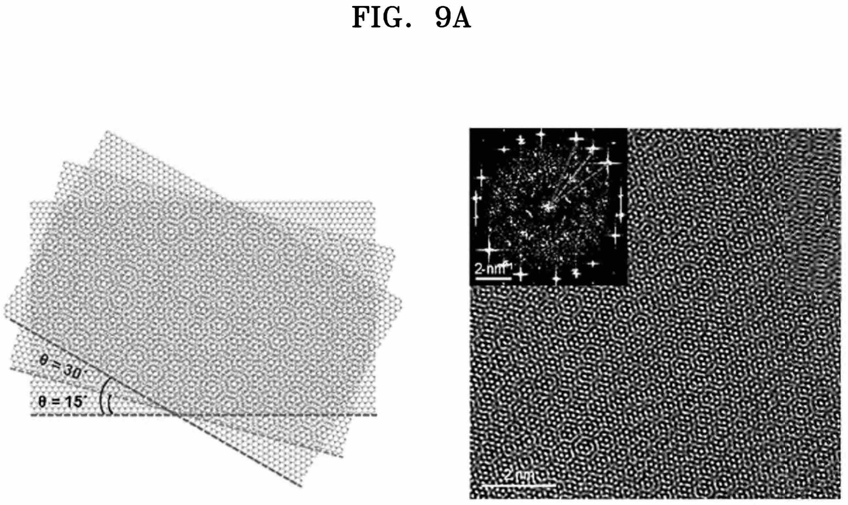

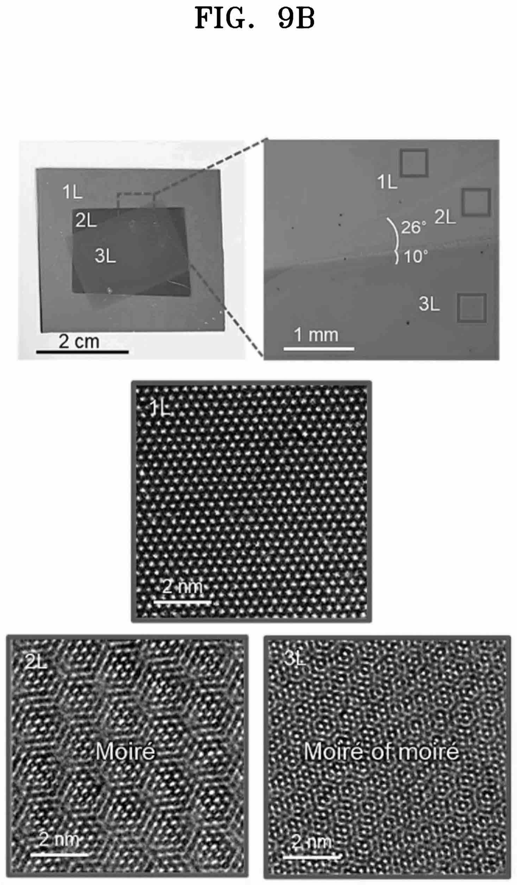

Regarding the MoS₂/MoS₂/MoS₂ thin film of Example 13 or Example 14, diffraction patterns, optical microscope images, and TEM images were obtained. The results are shown in FIGS. 9A and 9B.

FIG. 9A shows a schematic diagram, a diffraction pattern, and a TEM image of the MoS₂ single-crystal layer of Example 13 at a clockwise twist angle (or stacking angle) during the 2^{nd} hypotaxial growth and the 3^{rd} hypotaxial growth. FIG. 9B shows a schematic diagram showing the angles (or stacking angles) at which the MoS₂ layers were twisted clockwise during the 2^{nd} hypotaxial growth and the 3^{rd} hypotaxial growth when the MoS₂/MoS₂/MoS₂ super-moiréthin-film structure of Example 14 in a large area of several centimeters, and also shows optical microscope images and TEM images for the indicated area (dotted box, solid box);

Referring to FIGS. 9A and FIG. 9B, regarding the crystal orientation of the 2^{nd} MoS₂ nucleus grown by the 2^{nd} hypotaxy and the 3^{rd} MoS₂ nucleus grown by the 3^{rd} hypotaxy in Examples 13 and 14, it was confirmed that, even if the MoS₂/MoS₂/MoS₂ thin film was prepared with a large-area structure, the MoS₂/MoS₂/MoS₂ thin film was twisted clockwise and stacked in the same manner as in the schematic diagram on the left to ensure that the angle could be precisely controlled. It was also observed that the MoS₂/MoS₂/MoS₂ thin films of Examples 13 and 14 had clean nanometer-scale super-moiré patterns without any polymer contamination or interlayer bubbles, moiré patterns and super-moiré patterns, or moiré patterns, and the surface on which the MoS₂ single crystals were formed.

### Evaluation Example 7: Thin-film characteristics of MoS₂ single-crystal/MoS₂ polycrystal of Example 15- Moiré domain

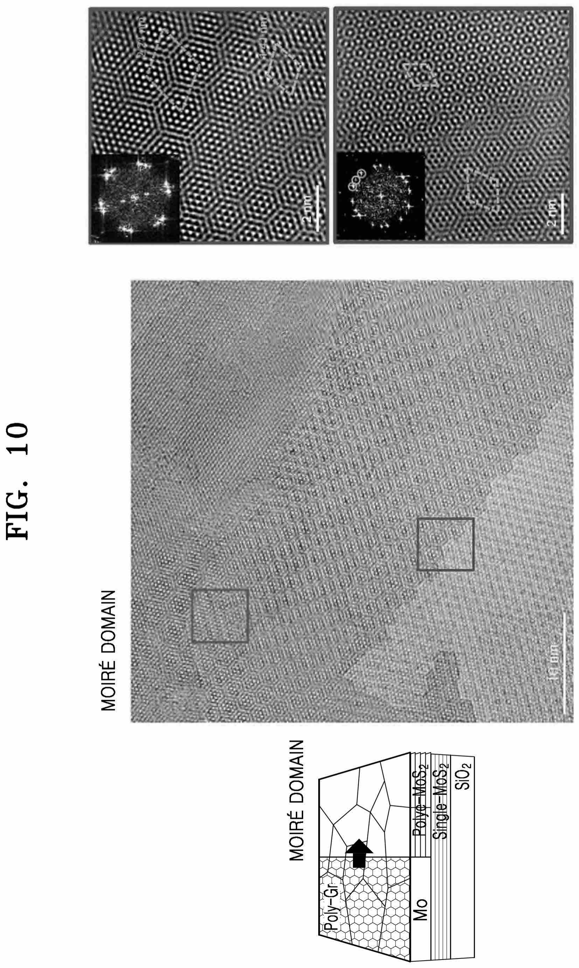

Regarding the surface of the MoS₂ single-crystal/MoS₂ polycrystal thin-film structure of Example 15 (schematic diagram on the left), a low-magnification TEM image (in the middle) using false-color and an enlarged TEM image and a diffraction pattern (on the right) of the indicated area were obtained. The results are shown in FIG. 10.

Referring to FIG. 10, the MoS₂ single-crystal/MoS₂ polycrystal thin-film structure of Example 15 had a moiré domain in which various moiré periods of several nanometers to several tens of nanometers in a horizontal direction or in-plane direction are created and regions having moiré patterns of the same period are combined.

### Evaluation Example 8: Thin-film characteristics of MoS₂/WS₂ of Example 16-Single-crystal layer of combination of heterogeneous materials

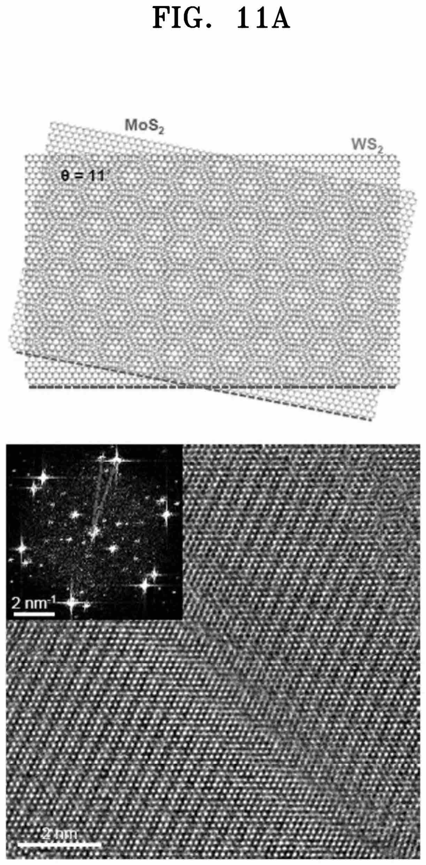

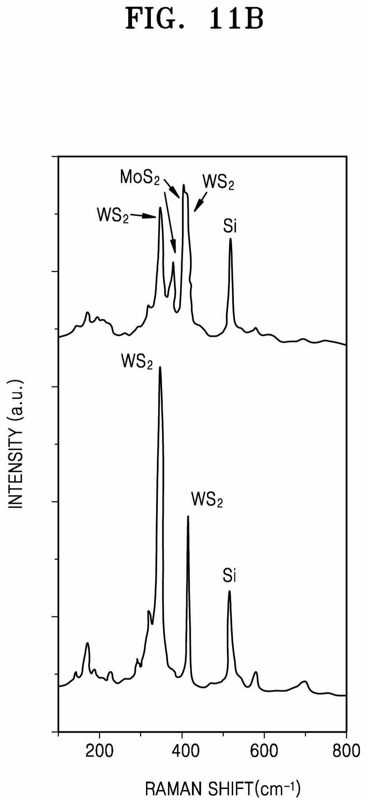

Regarding the surface of the MoS₂/WS₂ thin film of Example 16, a TEM image and a diffraction pattern were obtained, and a Raman spectrum thereof in a high-wavelength region was analyzed. The results are shown in FIGS. 11A and 11B.

Referring to FIGS. 11A and B, the MoS₂/WS₂ thin-film structure of Example 16 was a single-crystal layer of the heterogeneous material combination, exhibited clean and uniform moiré patterns as in the single-crystal layer of the same material combination, and had a modified Raman spectrum.

Such a heterostructure including the multi-layered thin-film structure according to an embodiment may include two or more layers that have different lattice periods and are attached to form a thin film having a new periods, thereby controlling quantum states. Examples of the quantum states may include, through interlayer interactions in graphene at specific stacking angles, superconductivity, magnetic twin state, disordered electronic state, and the like. In such states, the mobility, spinning state, and coherence of electrons may be precisely controlled, and thus the multi-layered thin-film structure according to an embodiment may be applied as a fundamental material for applications in fields of quantum computing and quantum communications. These unique quantum mechanical properties of the moiré patterns allow for extremely precise control of materials, enabling the development of new nano-scale electronic devices. For example, quantum dots may be formed by using the moiré patterns, and accordingly, single photon sources or quantum bits may be implemented.

According to the one or more embodiments, a moiré material based on a van der Waals stacking structure according to an embodiment may include a multi-layered thin-film structure in which each layer has an independent crystal orientation and an independent crystal structure in a vertical direction, the multi-layered thin-film structure having interference fringes of the same or different periodic patterns in a horizontal direction of a single plane, depending on a superimposed angle among layers, or has an atomic reconstruction phenomenon in a plane. The multi-layered thin-film structure may have, regardless of a substrate, an atomic reconstruction phenomenon or a variety of periodic patterns even in large-area sizes with a desired number of layers, a combination of materials, a stacking angle, a crystal orientation, a crystal structure, and an in-plane direction, or may have a uniform surface without defects. Therefore, the moiré material based on a van der Waals stacking structure according to an embodiment may be applied to electronic devices in various fields.

**It** should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope of the disclosure as defined by the following claims.

## Claims

1. A moiré material based on a van der Waals stacking structure, comprising a multi-layered thin-film structure in which each layer has an independent crystal orientation and an independent crystal structure in a vertical direction,
wherein the multi-layered thin-film structure has interference fringes of the same or different periodic patterns in a horizontal direction of a single plane, depending on a superimposed angle among layers, or shows an atomic reconstruction phenomenon in a plane.

2. The moiré material of claim 1, wherein materials of each layer of the multi-layered thin-film structure are the same or different from each other.

3. The moiré material of claim 1, wherein the multi-layered thin-film structure includes a metal chalcogenide compound, a metal oxide, a metal or metalloid carbide compound, a metal or metalloid nitride compound, or a combination thereof.

4. The moiré material of claim 1, wherein the multi-layered thin-film structure has a crystal structure independent of a crystal structure or an amorphous structure of a substrate.

5. The moiré material of claim 1, wherein the interference fringes of the periodic patterns of the multi-layered thin-film structure are a moiré pattern, a super-moiré pattern, or a combination thereof.

6. The moiré material of claim 1, wherein the atomic reconstruction phenomenon within a single plane appears when the superimposed angle among layers of the multi-layered thin-film structure is at a critical angle of 5° or less.

7. A method of preparing a moiré material based on a van der Waals stacking structure through hypotaxial growth, the method comprising:
forming a first raw material thin-film layer on at least one surface of a substrate;
arranging a two-dimensional crystalline first template on the first raw material thin-film layer;
supplying a gas supply source containing a second raw material onto the first raw material thin-film layer on which the two-dimensional crystalline first template is arranged, followed by performing first heat treatment, to form a crystalline first thin-film layer including a first raw material and a second raw material;
forming a third raw material thin-film layer on the crystalline first thin-film layer;
arranging a two-dimensional crystalline second template at a twisted angle on the third raw material thin-film layer; and
supplying a gas supply source containing a fourth raw material onto the third raw material thin-film layer on which the two-dimensional crystalline second template is arranged, followed by performing second heat treatment, to form a crystalline second thin-film layer including a third raw material and a fourth raw material,
wherein the crystalline first thin-film layer and the crystalline second thin-film layer are layers of crystals aligned through hypotaxial growth in a downward direction from the bottom of the two-dimensional crystalline first template and the bottom of the two-dimensional crystalline second template, respectively.

8. The method of claim 7 , wherein the first raw material thin-film layer and the third raw material thin-film layer include at least one metal or alloy selected from Nb, Mo, Tc, Ru, Rh, Pd, Ag, Cd, Hf, Ta, W, Re, Os, Ir, Pt, Au, Hg, Rf, Db, Sg, Bh, Hs, Mt, Ds, Rg, Cn, Sc, Ti, V, Cr, Mn, Fe, Co, Ni, Cu, Zn, Y, and Zr.

9. The method of claim 7 , wherein the gas supply source containing a second raw material and the gas supply source containing a fourth raw material include at least one element selected from S, Se, Te, C, N, and O.

10. The method of claim 7, wherein the two-dimensional crystalline first template and the two-dimensional crystalline second template include graphene, hexagonal boron nitride (hBN), a transition metal chalcogen compound, a graphene oxide, a metal oxide, black phosphorus, phosphorene, a polymer material, or a combination thereof.

11. The method of claim 7 , wherein a defective portion of each of the two-dimensional crystalline first template and the two-dimensional crystalline second template includes 3-fold symmetry nanopores or 6-fold symmetry nanopores.

12. The method of claim 7 , wherein the two-dimensional crystalline first template and the two-dimensional crystalline second template are each a sacrificial template, and
the sacrificial template is removed partially or completely.

13. The method of claim7 , wherein the first heat treatment and the second heat treatment are each performed at a temperature in a range of about 200 °C to about 1100 °C for about 5 minutes to about 20 hours.

14. The method of claim7 , wherein the crystalline first thin-film layer and the crystalline second thin-film layer include MoS₂, MoSe₂, MoTe₂, WS₂, WSe₂, WTe₂, In₂Se₃, Cr₂Se₃, Sb₂O₃, MoO₃, or a combination thereof.

15. An electronic device comprising the moiré material of claim 1.
